# EUROPÄISCHE PATENTSCHRIFT

(11) **EP 1 804 275 B1**
(45) Veröffentlichungstag und Bekanntmachung des Hinweises auf die Patenterteilung: **11.03.2009**
(21) Anmeldenummer: 05028124.5
(22) Anmeldetag: 22.12.2005
(51) Int. Cl.: H01J 37/34, C23C 14/34

(54) **Zerstäubungsvorrichtung mit einer Rohrkathode und Verfahren zum Betreiben dieser Zerstäubungsvorrichtung**
Sputter device with a tubular cathode and process of operating the sputter device
Dispositif de pulvérisation ayant une cathode tubulaire tournante et procédé pour la mise en oeuvre du dispositif

(43) Veröffentlichungstag der Anmeldung: 04.07.2007
(73) Patentinhaber: Applied Materials GmbH & Co. KG, 63755 Alzenau (DE)
(72) Erfinder: Henrich, Jürgen, 63694 Limeshain (DE); Sauer, Andreas, 63762 Grossostheim (DE); Geiss, Andreas, 63452 Hanau (DE); Brinckmann, Felix, 64283 Darmstadt (DE)
(74) Vertreter: Schickedanz, Willi

(56) Entgegenhaltungen:
- EP-A- 0 703 599
- US-A- 5 814 195
- US-A1- 2004 149 576
- WRIGHT M ET AL: "Design advances and applications of the rotatable cylindrical magnetron" JOURNAL OF VACUUM SCIENCE AND TECHNOLOGY: PART A, AVS /AIP, MELVILLE, NY, US, Bd. 4, Nr. 3, 1986, Seiten 388-392, XP002314779 ISSN: 0734-2101

## Beschreibung

Die Erfindung betrifft eine Zerstäubungsvorrichtung nach dem Oberbegriff des Patentanspruchs 1 und ein Verfahren nach Anspruch 17.

Das Aufbringen von Schichten auf Substrate geschieht häufig mittels eines Zerstäubungsprozesses. Bei diesem Zerstäubungsprozess werden Substrate, beispielsweise Glas oder Kunststofffolien, in eine Vakuumkammer eingebracht, in der sich ein Plasma befindet.

Die positiven Ionen des Plasmas werden dabei auf ein Target bewegt, welches sich an einer Kathode befindet. Diese positiven Ionen schlagen aus dem Target Teilchen heraus, wobei sich diese Teilchen auf das zu beschichtende Substrat zu bewegen und sich dort niederschlagen.

Häufig werden in der Nähe der Targets Dauermagnete angeordnet, um die Anzahl der Ionen im Plasma zu erhöhen, wodurch noch mehr Teilchen aus dem Target herausgeschlagen werden können. Eine solche Kombination aus Dauermagneten und Kathode wird als Magnetron bezeichnet.

Grundsätzlich wird dabei zwischen planaren und runden oder rohrförmigen Magnetrons unterschieden.

Bei den rohrförmigen Magnetrons wird auf die Außenseite einer zylindrischen Kathode ein rohrförmiges Target aufgesetzt. Diese Gesamtanordnung kann um die Längsachse der Kathode rotieren. Da die Targetmaterialausbeute bei diesen rohrförmigen Magnetrons höher ist als bei den planaren Magnetrons, gewinnen diese rohrförmigen Magnetrons immer mehr an Bedeutung.

So ist ein zylindrisches Magnetron bekannt, das sich in einer Vakuumkammer befindet (EP 0 500 774 B1). Dabei dreht sich die Targetkonstruktion um ihre Längsachse, wobei die Magnete ortsfest angebracht sind.

Des Weiteren ist eine um die Längsachse rotierende Magnetron-Kathode bekannt, die eine solche Magnetanordnung besitzt, dass zwei verschiedene sich gegenüber liegende Substrate gleichzeitig beschichtet werden (DE 41 26 236 A1).

Eine Drehkathode mit mindestens einem darauf angebrachten Target ist ebenfalls beschrieben (EP 0 703 599). Anstatt sich um die eigene Längsachse zu drehen, führt die Drehkathode eine schwingende Drehbewegung aus, wobei der Schwingungswinkel bis zu 90° beträgt. Hierdurch soll die Aufgabe gelöst werden, das Targetmaterial schnell und ohne Öffnen der Vakuumanlage wechseln zu können.

Bekannt ist auch eine Beschichtungsanlage mit einem Magnetron, mit der Substrate beschichtet werden können (Michael Wright and Terry Beardow, Design advances and applications to the rotatable cylindrical magnetron, J. Vac. Sci. Technol. A 4 (3), May/Jun 1986). Bei diesem Magnetron kann zum einen das Target um ein unbewegliches Magnetsystem bewegt werden oder es kann ein Magnetsystem innerhalb eines fest angeordneten Targets rotiert werden. In beiden Fällen wird das Magnetron zumindest teilweise von einer Abschirmung umgeben. Des Weiteren ist dort ein Magnetron beschrieben, um das keine Abschirmung angeordnet ist.

Weiterhin ist ein Beschichtungssystem bekannt, dass eine Beschichtungskammer aufweist, in der zwei Magnetrons nebeneinander angeordnet sind (US 5,814,195). Diese Magnetrons werden bei einer Wechselspannung im Bereich von 10 bis 100 kHz betrieben. Dadurch kann ein Substrat nicht nur beschichtet werden, sondern es wird auch verhindert, dass sich dielektrisches Material auf dem Target ablagert. Die Stromzuführung erfolgt dabei über Stromabnehmer, die mit den jeweiligen Magnetrons in Kontakt stehen.

Schließlich ist eine Beschichtungsanlage mit einer drehbaren Rohrkatode bekannt, bei der die Energieversorgung ebenfalls über Stromabnehmer, nämlich Bürsten, erfolgt. Auch diese Bürsten stehen mit der Rohrkatode in Kontakt (US 2004/0149576 A1).

Der Erfindung liegt die Aufgabe zugrunde, eine Zerstäubungsvorrichtung mit einer Rohrkathode bereit zu stellen, wobei die Versorgung der Rohrkathode über flexible Leitungselemente erfolgt.

Diese Aufgabe wird gemäß den Merkmalen der Ansprüche 1 und 18 gelöst.

Die Erfindung betrifft somit eine Zerstäubungsvorrichtung mit einer Rohrkathode und ein Verfahren zum Betreiben dieser Zerstäubungsvorrichtung. Die Zufuhr von Strom, Kühlflüssigkeit und anderen Medien zur Rohrkathode erfolgt dabei über flexible Leitungen bzw. Rohre, die um einen Aufnehmer wickelbar sind. Übt die Rohrkathode eine Pendelbewegung aus, werden die Leitungen und/oder Rohre auf den Aufnehmer auf- bzw. von diesem abgewickelt. Die Pendelbewegung der Rohrkathode ist dabei vorzugsweise derart, dass die Rohrkathode um einen bestimmten ersten Winkel in eine erste Richtung und anschließend in einem bestimmten zweiten Winkel in einer zweiten Richtung gedreht wird, wobei sich der zweite Winkel vom ersten Winkel unterscheidet.

Der mit der Erfindung erzielte Vorteil besteht insbesondere darin, dass die Versorgung mit Kühlflüssigkeit und/oder Strom über flexible Leitungen bzw. Schläuche erfolgen kann. Das Anbringen einer rotierenden Dichtung z. B. bei der Wasserdrehdurchführung entfällt damit, da es nicht mehr nötig ist, das Kühlmedium von einem statischen zu einem rotierenden Teil zu übertragen. Der Wasserschlauch wird direkt an die rotierende Rohrkathode angebracht.

Die technisch sehr aufwändigen Wasserdrehdurchführungen benötigen zudem viel Raum, sodass die erfindungsgemäße Lösung zudem Platz sparend ist.

Vorteilhaft ist bei der Erfindung auch, dass es möglich ist, die Rohrkathode zum Beispiel über ein Kabel mit Strom zu versorgen, womit auf die technisch aufwändige Funktionskomponente einer Schleifkontaktierung verzichtet werden kann und der Stromstärke somit keine Grenzen gesetzt sind. Die Sputterleistung kann damit erhöht werden. Nachteilig an der herkömmlichen Schleifkontaktierung ist die Erzeugung von Partikeln. Diese Partikel können sich bei Kontaktierung im Vakuum auf den zu beschichtenden Substraten absetzen, was zu Pinhole-Bildung der Beschichtung führt. Sind die Schleifkontakte und damit die Leistungszuführungen atmosphärenseitig angeordnet, so können bei Verwendung von Wechselstrom die metallischen Bauteile von Lager und Drehdurchführung durch Wirbelströme beschädigt werden.

Ein weiterer Vorteil der Erfindung besteht darin, dass auch flexible Mess- oder Signalleitungen mit der Rohrkathode verbunden werden können. Hierdurch ist es zum Beispiel möglich, die Targettemperatur zu ermitteln. Droht die Targettemperatur einen kritischen Wert zu erreichen oder zu übersteigen, kann über eine Steuerungsleitung die Kühlmittelversorgung erhöht werden.

Die Anbringung der flexiblen Versorgungselemente erfolgt in der Art und Weise, dass die Rohrkathode wie bei den herkömmlichen Sputterverfahren auch weiterhin um mindestens 360° um die eigene Längsachse gedreht werden kann. Dabei erfolgt die Drehung in Form einer diskontinuierlichen Rundbewegung, wobei ein gleichmäßiger Abtrag des Targetmaterials und damit eine gleichmäßige Beschichtung des Substrats auch weiterhin gegeben ist.

Ferner liegt ein Vorteil der Erfindung auch darin, dass die Wartung der Beschichtungsanlage erleichtert ist, da die technisch aufwändigen Vorrichtungen der Wasserdrehdurchführung und die Schleifkontaktierung nicht mehr vorhanden sind.

Schließlich ist die Erfindung auch weniger anfällig für Verschleiß.

Ein Ausführungsbeispiel der Erfindung ist in den Zeichnungen dargestellt und wird im Folgenden näher beschrieben. Es zeigen:
Fig. 1 einen Schnitt durch eine Vakuumkammer mit einem Ausschnitt einer daran angeschlossenen Vorvakuumkammer;
Fig. 2 eine Draufsicht auf einen Ausschnitt der in Fig. 1 dargestellten Vakuumkammer mit der daran angeschlossenen Vorvakuumkammer;
Fig. 3 einen Längsschnitt durch die in Fig. 1 dargestellte Rohrkathode;
Fig. 4 einen Schnitt B-B durch die in Fig. 1 dargestellte Rohrkathode;
Fig. 5a einen Schnitt entlang C-C durch einen Ausschnitt der in Fig. 1 dargestellten Vorvakuumkammer mit einem Aufnehmer und daran angeschlossenen Leitungselementen für die Stromversorgung;
Fig. 5b einen Schnitt entlang C-C durch einen Ausschnitt der in Fig. 1 dargestellten Vorvakuumkammer mit einem Aufnehmer und daran angeschlossenen Leitungselementen für die Kühlmittelversorgung;
Fig. 6 einen vergrößerten Ausschnitt der in Fig. 1 dargestellten Rohrkathode mit der Achse;
Fig. 7 einen Ausschnitt einer Bandfeder mit mehreren Leitungselementen.

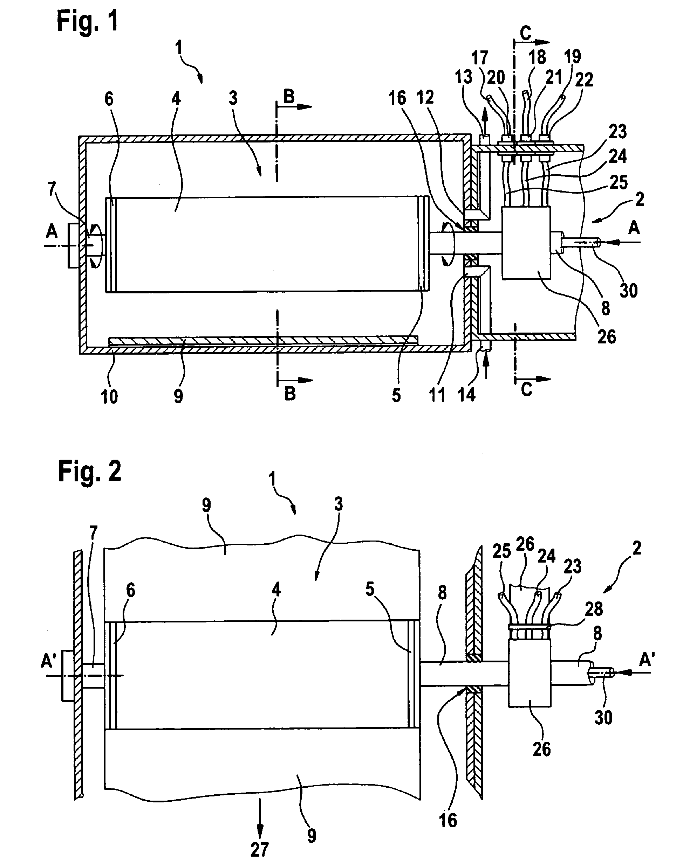

In Fig. 1 ist ein Längsschnitt durch eine Vakuumkammer 1 einer Zerstäubungsvorrichtung mit einer daran angeschlossenen Vorvakuumkammer 2 dargestellt, wobei nur ein Ausschnitt dieser Vorvakuumkammer gezeigt ist. In der Vakuumkammer 1 befindet sich eine Rohrkathode 3 mit einem aufgesetzten zylindrischen Target 4, welches über Verbindungselemente 5, 6 gehalten wird.

Die Rohrkathode 3 ist auf einer Achse 7, 8 gelagert, sodass die Rohrkathode 3 samt Target 4 mit der Achse 7, 8 um die eigene Längsachse rotieren kann. Dadurch wird ein gleichmäßiger Abtrag des Targetmaterials erreicht, wobei das Substrat 9 unterhalb der Rohrkathode 3 angeordnet ist. Das Substrat 9 und die Rohrkathode 3 mit dem darauf angebrachten Target 4 werden relativ zueinander bewegt, d. h. das Substrat 9 wird in die Zeichenebene hinein oder aus dieser heraus bewegt.

Bei dem Substrat 9 kann es sich zum Beispiel um eine Kunststofffolie oder Glas handeln. Die Achse 7, 8 ist als Rohr ausgebildet, wobei in der Achse 7, 8 ein inneres Rohr 30 vorgesehen ist. Über dieses Rohr 30 kann von außen Kühlmittel zugeführt werden, welches zur Kühlung der Rohrkathode 3 dient.

In der Wand 10 der Vakuumkammer 1 sind eine Öffnung 11 für einen Gaseinlass 14 und eine weitere Öffnung 12 für einen Gasauslass 13 zu sehen, wobei wenigstens der Gaseinlass 14 mit einem Pumpsystem verbunden ist, das jedoch nicht dargestellt ist.

Über den Gasauslass 13 bzw. den Gaseinlass 14 kann nicht nur ein entsprechendes Vakuum erzeugt werden, sondern es kann die Vakuumkammer 1 zudem mit einem Gas versorgt werden. Dabei handelt es sich vorzugsweise um ein Edelgas wie z. B. Ar. Es kann jedoch auch ein Reaktivgas hinzugesetzt werden, wenn ein reaktives Sputtern gewünscht ist.

Die Achse 8 führt aus der Vakuumkammer 1 über eine vakuumdichte Drehdurchführung 16 in die Vorvakuumkammer 2, wenn die Anschlüsse in Atmosphäre liegen. Liegen die Anschlüsse im Vorvakuum, so bezeichnet die Bezugszahl 16 ein Lager.

Die Achse 8 ist mit einem nicht dargestellten Antrieb verbunden, der gewährleistet, dass die Rohrkathode 3 um die eigene Achse rotieren kann.

In Fig. 1 sind ferner mehrere flexible Leitungselemente 17 bis 19 dargestellt, die mit Anschlüssen 20 bis 22 der Vorvakuumkammer 2 verbunden sind. Bei diesen Leitungselementen kann es sich beispielsweise um Kabel - zum Leiten von Strom - oder Schläuche - zum Transportieren von Kühlmittel - handeln.

In der Vorvakuumkammer 2 führen weitere flexible Leitungselemente 23, 24, 25 in Richtung der Achse 8, wobei die Leitungselemente 23 bis 25 auf einer Bandfeder 26 befestigt sind und gewissermaßen die Fortsetzungen der Leitungselemente 17 bis 19 dargestellt. Somit wird nicht jedes Leitungselement 23 bis 25 einzeln um die Achse 8 gerollt, sondern, da alle Leitungselemente auf der Bandfeder 26 fest angeordnet sind, alle zusammen. Statt einer Bandfeder 26 kann auch eine Kabeltrommel mit Rückwickelfeder gewählt werden.

Auch bei den Leitungselementen 23 bis 25 handelt es sich vorzugsweise um Schläuche oder Kabel. Die Enden der Schläuche sind - was in Fig. 1 nicht erkennbar ist - in Rohren geführt, die innerhalb der Achse 8 verlaufen und Kühlmittel zum Target transportieren.

Über diese über die Anschlüsse 20 bis 22 miteinander verbundenen Leitungselemente 17, 25; 18, 24; 19, 23 kann über ein weiter unten noch näher beschriebenes Rohrsystem durch die Achse 8 Strom bzw. Kühlmittel geleitet werden, sodass Spannung an die Rohrkathode 3 gelegt und/oder Kühlflüssigkeit dem Target zugeführt wird.

Es ist aber auch möglich, neben Kühlschläuchen und Energieleitungen auch Signalleitungen zu verlegen, deren eines Ende zum Beispiel mit einer Messvorrichtung und deren anderes Ende mit einem Sensor verbunden werden kann, wobei dieser Sensor in der Achse 8 untergebracht ist. Dadurch ist es möglich, z. B. die Spannung an der Kathode oder die Temperatur des Kühlmittels zu messen.

Durch Anbringen dieser Sensoren ist es möglich, den Sputterprozess optimal zu steuern. Somit können neben den Leitungselementen für die Strom- bzw. die Kühlmittelzuführung beliebig viele Leitungselemente für die Messung von diversen Parametern in der Vorvakuumkammer 2 angeordnet sein.

Die Leitungselemente 23 bis 25 können auch in der Vakuumkammer 1 selbst angeordnet sein. Dazu ist es jedoch nötig, dass zumindest die Stromkabel isoliert sind. Sind die Stromkabel nicht isoliert, könnte es durch Kontakt mit dem Plasma zu Überschlägen kommen. Um einen Kontakt mit der geerdeten Wand der Vakuumkammer 1 zu verhindern, ist diese Wand mit einer Überschlags- oder Durchschlagssicherung, d. h. einer Isolierung versehen. In diesem Fall sollte aber auch die Bandfeder anstatt aus Federstahl aus einem dielektrischen Faser- oder Verbundmaterial bestehen, damit die Leitungen nicht unter einander kontaktieren. Die Bandfeder 26 kann auch selbst als Zuführung von Sputterleistung dienen. Sie sollte dann beispielsweise aus Kupfer-Beryllium bestehen. Die Leitungselemente 23 bis 25 sollten aus einem gasundurchlässigen Material bestehen, da ansonsten die Gefahr besteht, dass z. B. Kühlmittel aus einem gasdurchlässigen Leitungselement tritt und damit den Sputterprozess beeinflusst. Einfacher ist es hingegen, die Leitungselemente außerhalb der Sputteranlage an der Atmosphäre anzuordnen, da dadurch eine Wartung erheblich erleichtert wird.

In jedem Fall ist das Anbringen der flexiblen Leitungselemente 23 bis 25 an der Achse 8 von großem Vorteil, da die technisch aufwändigen Funktionskomponenten einer herkömmlichen Schleifkontaktierung sowie einer Wasserdrehdurchführung nicht mehr nötig ist. Da auf eine Schleifkontaktierung verzichtet werden kann, sind auch der elektrischen Leistung fast keine Grenzen mehr gesetzt, wodurch auch die Sputterraten erhöht werden können.

Fig. 2 zeigt die relative Anordnung von Rohrkathode 3 und Substrat 9 in einer Ansicht von oben, bezogen auf die Darstellung der Fig. 1.

Man erkennt bei dieser Draufsicht einen Ausschnitt der in Fig. 1 dargestellten Vakuumkammer 1 mit der daran angebrachten Vorvakuumkammer 2. Das Target 4 ist auf der Rohrkathode 3 mittels der Verbindungselemente 5, 6 befestigt. Unterhalb der Rohrkathode 3 bewegt sich das Substrat 9 in Richtung des Pfeils 27. In der Vorvakuumkammer 2 sind die Leitungselemente 23 bis 25 zu erkennen, wie sie auf einer Bandfeder 26 aufliegen und dort mittels eines Befestigungselements 28 auf dieser Bandfeder 26 befestigt sind. Die Bandfeder 26 ist an der Wand der Vorvakuumkammer 2 befestigt, wie weiter unten noch näher beschrieben wird.

Die Bandfeder 26 ist zumindest teilweise mit samt den daran befestigten Leitungselementen 23 bis 25 auf der Achse 8 aufgerollt. Wird die Rohrkathode 3 nun in eine Richtung gedreht, so wird die Bandfeder 26 mit den daran angeordneten Leitungselementen 23 bis 25 auf- bzw. abgerollt, ohne dass die Leitungselemente 23 bis 25 von der Achse 8 gelöst werden.

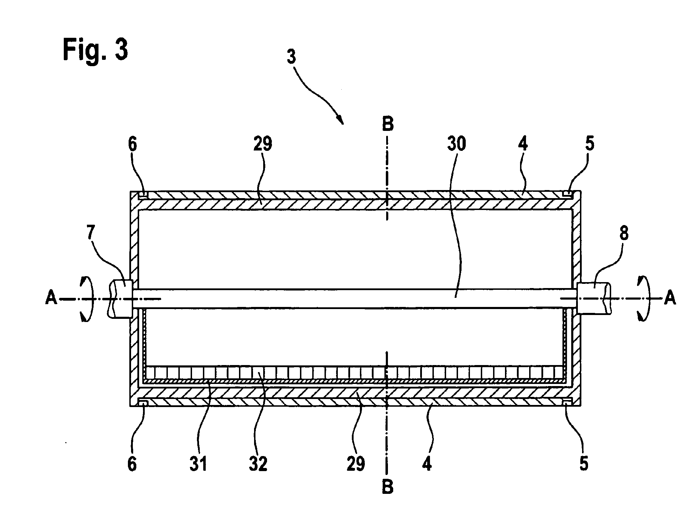

Fig. 3 zeigt einen Längsschnitt durch die in Fig. 1 dargestellte Rohrkathode 3. Zu erkennen ist wieder das zylinderförmige Target 4, das auf dem Targetträgerrohr 29 angeordnet und mittels Befestigungselementen 5, 6 gehalten wird. Entlang der Linie A-A verläuft das innere Rohr 30 als ein Teil der Achse 7, 8 durch die Rohrkathode 3. An diesem Rohr 30 ist eine Wanne 31 befestigt, in der mehrere Magnete angeordnet sind, von denen ein Magnet 32 mittels einer Bezugszahl gekennzeichnet ist.

Wird die Rohrkathode 3 nun um ihre Längsachse bewegt, so bewegt sich die Wanne 31 mit den darin befindlichen Magneten nicht mit. Die Wanne 31 ist damit - wie auch das Rohr 30 - ortsfest angeordnet.

Zwischen dem Target 4 und dem Targetträgerrohr 29 kann zudem eine Zwischenschicht vorgesehen sein, wobei es sich bei dieser Zwischenschicht um eine Haft- oder Trennschicht handeln kann, beispielsweise aus Grafit. Der Vorteil einer solchen Trennschicht liegt darin, dass das Target nach Beendigung des Prozesses leicht wieder vom Targetträgerrohr entfernt werden kann.

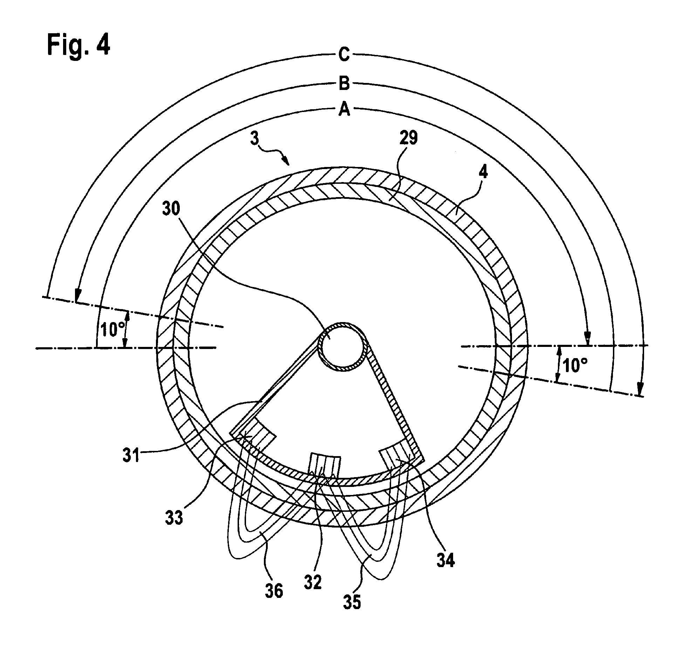

Fig. 4 zeigt einen Schnitt entlang B-B durch die in Fig. 1 dargestellte Rohrkathode 3.

Sie zeigt das Target 4, wie es direkt an dem Targetträgerrohr 29 aufliegt. Eine Zwischenschicht ist in diesem Beispiel nicht vorgesehen. Des Weiteren zeigt Fig. 4 die Wanne 31, die mit dem Rohr 30 in Verbindung steht. In der Wanne 31 sind drei Magnete 32 bis 34 gezeigt, die zwei Magnetfelder 35, 36 erzeugen. Da das Rohr 30 mit der daran angebrachten Wanne 31 ortsfest angeordnet ist, rotiert das Targetträgerrohr 29 mit dem daran angebrachten Target 4 um die Anordnung aus Rohr 30 und Wanne 31 mit den daran angeordneten Magneten 32 bis 34. Das Magnetfeld 35, 36 bleibt damit ebenfalls ortsfest, wodurch eine gleichmäßige Abtragung des Targets 4 gewährleistet wird, da sich dieses um seine eigene Längsachse bewegt. Hierdurch gerät jeder Bereich des Targets 4 in das Magnetfeld 35, 36, in dessen Bereich sich das Sputterplasma ausbildet, wodurch das Target 4 gleichmäßig abgetragen wird.

Die Rohrkathode 3 führt allerdings keine vollständige Bewegung von 360° oder mehr um die eigene Achse aus, sondern eine diskontinuierliche, wobei der Winkel, um den sich die Rohrkathode 3 bewegt, vorzugsweise zwischen 150° und 270° liegt. Anschließend wird die Rohrkathode 3 wieder in Richtung ihres Ausgangspunkts zurückbewegt. Es wird also eine Pendelbewegung durchgeführt. Die Rohrkathode 3 kann somit bis zu 1,5 Umdrehungen, d. h. um ±270° durchführen.

Um eine gleichmäßige azimutale Erosion des Targets zu gewährleisten, muss die Rohrkathode 3 längerfristig bzw. nach mehreren Pendelbewegungen um mindestens 360° gedreht werden, wodurch eine überlappende Erosion stattfinden kann. So kann die Rohrkathode 3, wie in Fig. 4 dargestellt, um beispielsweise 180° im Uhrzeigersinn gedreht werden, was durch den gekrümmten Pfeil A dargestellt ist, wobei die Rückdrehung, d. h. entgegen dem Uhrzeigersinn, um einen Winkel erfolgt, der um einen bestimmten Betrag kleiner oder auch größer ist. Ist der Winkel zum Beispiel um 10° kleiner, so wird die Rohrkathode 3 nur um 170° zurückgedreht, was durch den gekrümmten Pfeil B dargestellt ist, um dann wieder eine Drehbewegung um 180° im Uhrzeigersinn durchzuführen, vgl. gekrümmten Pfeil C. Diese diskontinuierliche Pendelbewegung wird mindestens so lange durchgeführt, bis sich die Rohrkathode 3 einmal um die eigene Achse gedreht hat. In diesem Fall, bei dem die Drehung im Uhrzeigersinn in einem Winkel von 180° und die Rückdrehung in einem Winkel von 170° erfolgen, findet die diskontinuierliche Pendelbewegung 36 Mal statt. Nachdem diese diskontinuierliche Pendelbewegung 36 Mal stattgefunden hat, hat sich die Rohrkathode 3 um 360°, d. h. einmal um die eigene Achse bewegt.

Die anfängliche Drehung kann anstatt bei einem Winkel von 180° ebenso bei einem Winkel von 270° liegen. Vorzugsweise liegt der Winkel dieser anfänglichen Drehbewegung jedoch zwischen 180° und 270°.

Hat sich die Rohrkathode 3 nach mehreren Pendelbewegungen insgesamt um die eigene Achse, d. h. um mindestens 360°, gedreht, so findet die Rückbewegung statt. Dabei erfolgt die Bewegung im Uhrzeigersinn in einem Winkel von 170° und entgegen dem Uhrzeigersinn um 180°. Zusätzlich kann im Umkehrpunkt der Drehbewegung eine Totzeit vorgesehen werden, bevor die Rückdrehung erfolgt. Diese Totzeit ist sehr klein, beispielsweise 0,5 Sekunden. Auf diese Weise kann ein eventuell ungleichmäßiger Abtrag vom Targetmaterial auf dem Umfang des Targets 4 im Bereich des Umkehrpunkts ausgeglichen werden.

Zusätzlich zur Totzeit kann die Rohrkathode 3 auch mit verschiedenen Geschwindigkeitsprofilen gedreht werden, wobei über den größten Teil des Drehwinkels die Geschwindigkeit konstant gehalten wird. Nur nahe des Umkehrpunktes ist eine Abweichung dieser konstanten Geschwindigkeit erlaubt. Dabei wird über das Geschwindigkeitsprofil an diesem Umkehrpunkt die Verweildauer des Plasmas über dem Target so eingestellt, dass durch den Abtrag keine Stellen mit ungleichmäßiger Erosion auftreten.

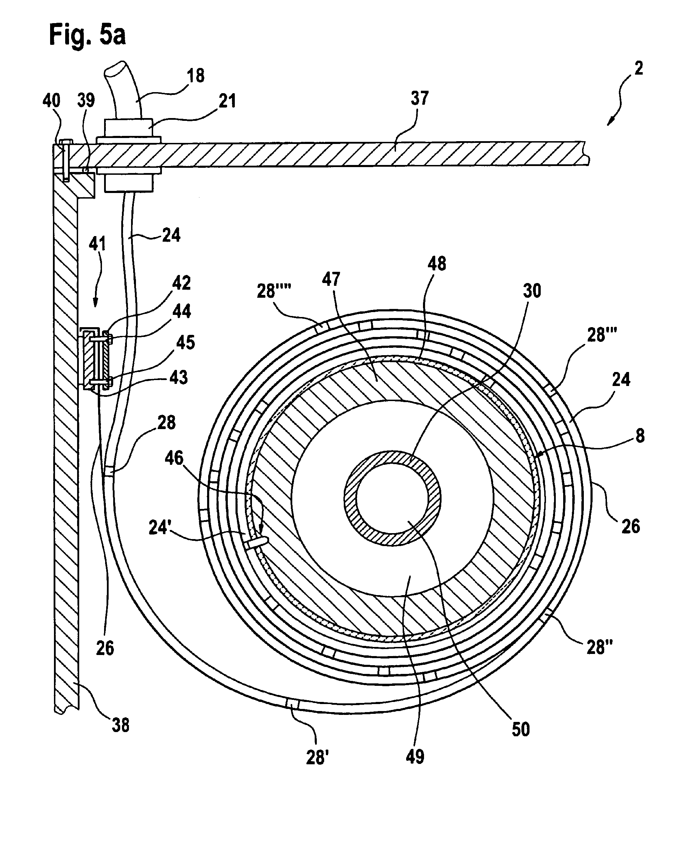

In Fig. 5a ist ein Schnitt entlang C-C durch einen Ausschnitt der in Fig. 1 dargestellten Vorvakuumkammer 2 mit der Achse 8 und dem daran angeschlossenen Leitungselement 24 für die Stromversorgung gezeigt. Die Leitungen für die Zuführung von Kühlflüssigkeit sind hierbei weggelassen. Zu erkennen ist eine Abdeckung 37 der Vorvakuumkammer 2, die auf einer Seitenwand 38 angeordnet ist. Die Abdeckung 37 ist über ein Verbindungselement 40, z. B. eine Schraube, mit der Seitenwand 38 verbunden, wobei zwischen der Seitenwand 38 und der Abdeckung 37 ein abdichtendes, vorzugsweise gummielastisches Material 39 angeordnet ist, sodass in der Vorvakuumkammer 2 ein Vakuum angelegt werden kann. Die Abdeckung 37 weist, wie hier dargestellt, einen Anschluss 21 auf, in den von außen ein Leitungselement 18 eingeführt und befestigt werden kann. Bei diesem Leitungselement 18 handelt es sich um ein Kabel für die Stromversorgung der Rohrkathode 3. Es ist jedoch auch möglich, dass es sich bei dem im Wesentlichen flexiblen Leitungselement 18 um eine Mess-, Steuerungs- oder Signalleitung handelt. Über die Steuerungsleitung können beispielsweise die Magnetsysteme geändert oder deren Abstand zum Targetrohr geändert werden.

Von dem Anschluss 21 führt ein anderes Leitungselement 24 hin zur Achse 8. Dabei weist das Leitungselement 24 im Wesentlichen die gleichen Eigenschaften wie das Leitungselement 18 auf.

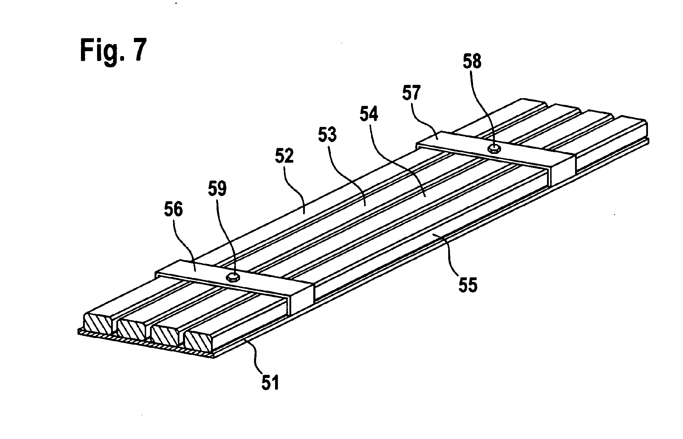

Das Leitungselement 24 verläuft entlang der Seitenwand 38 in Richtung einer Befestigungsvorrichtung 41 für die Bandfeder 26. Das Leitungselement 24 wird mit der Bandfeder 26 über Elemente 28, 28', 28" verbunden, wobei auf der Bandfeder auch noch andere Leitungselemente 23, 25 befestigt sind, wie in Fig. 2 gezeigt und anhand Fig. 7 näher erläutert.

Die Bandfeder 26 ist samt dem an ihr befestigten Leitungselement 24 um die Achse 8 mehrfach gewickelt. Dadurch, dass die Bandfeder 26 aus einem festen, aber dennoch flexiblen Material besteht, wie zum Beispiel aus einem dünnen Stahlblech, kann sie um die Achse 8 gewickelt werden.

Das Ende 24' des flexiblen Leitungselements 24 ist über eine Klemm- oder Steckvorrichtung 46 mit dem äußeren Ring 47 als einem drehbaren Aufnehmer der Achse 8 verbunden. Bei dieser Vorrichtung 46 kann es sich auch um eine Kombination aus Steck- und Klemmvorrichtung handeln. Der äußere Ring 47 besteht aus einem Material mit sehr guter Leitfähigkeit und ist vorzugsweise mit einem isolierenden Material isoliert. Es können aber auch die Leitungselemente 23 bis 25 von einer isolierenden Schicht umgeben sein.

Da, wie in Fig. 5a zu erkennen, das Leitungselement 24 nur mit dem äußeren Ring 47 des Rohrsystems der Achse 8 verbunden ist, handelt es sich somit um das Leitungselement, welches die Rohrkathode 3 (Fig. 4) mit Spannung versorgt.

Die Achse 8 verfügt zudem über zwei durch das fest angeordnete Rohr 30 abgetrennte Bereiche 49 und 50. Der Bereich 49 dient dabei als Zufluss für ein Kühlmittel, während der Bereich 50 als Abfluss dient. Die Funktionen der Bereiche 49 und 50 können auch umgekehrt sein.

Die Bandfeder 26 ist an der Befestigungsvorrichtung 41 befestigt. Die Bandfeder 26 ist dabei zwischen zwei Platten 42, 43 eingespannt, wobei die beiden Platten 42, 43 durch Verbindungselemente 44, 45, beispielsweise Schrauben, verbunden sind. Die geerdete Kammerwand ist auf der Innenseite mit einer Isolierschicht versehen, sodass parasitäre Plasmaentladungen zwischen Stromzufuhr und Kammerwand vermieden werden. Die Überschlagsicherung ist insbesondere dann von Bedeutung, wenn der Bereich der Stromzufuhr im Prozessvakuum oder im Vorvakuum liegt.

Wird nun, wie bereits bei Fig. 4 beschrieben, die Rohrkathode 3 um die eigene Achse bewegt, so bewegt sich auch der äußere Ring 47 bzw. auch die dort angebrachte Isolierschicht 48 mit, während das Rohr 30 nicht mit bewegt wird. Durch diese Bewegung um beispielsweise 180° im Uhrzeigersinn wird die Bandfeder 26 und das daran befestigte Leitungselement 24 teilweise abgerollt. Wird die Rohrkathode 3 hingegen entgegen dem Uhrzeigersinn beispielsweise um 170° gedreht, so wird die Bandfeder 26 samt dem an ihr angebrachten Leitungselement 24 wieder aufgerollt.

Damit die Rohrkathode 3 um mindestens 360° gedreht werden kann - und zwar in einer unter Fig. 4 beschriebenen Pendelbewegung -, ist eine Länge an Leitungselement 24 bzw. an Bandfeder 26 nötig, die mindestens der Länge entspricht, die nötig ist, um mit der Klemm- bzw. der Steckverbindung 46 verbunden zu werden, plus einer Länge, die der Länge entspricht, die erforderlich ist, die Bandfeder 26 mit dem an ihr angebrachten Leitungselement 24 einmal um die Achse 8 zu wickeln.

Es ist jedoch von Vorteil, wenn das Leitungselement 24 sowie die Bandfeder 26 eine noch größere Länge aufweisen. Damit müssen auch die anderen Leitungselemente 23, 25 eine solche Mindestlänge aufweisen, die hier jedoch nicht abgebildet sind.

In der Fig. 5a ist das Kabel 18 dicker als das Kabel 24 in der Vorvakuumkammer dargestellt. Beide Kabel 18, 24 können jedoch denselben Durchmesser haben. Mit der Darstellung der Fig. 5a soll gezeigt werden, dass es sich um den Übergang von einem Rundkabel außerhalb der Anlage auf ein Flachkabel innerhalb der Anlage handelt, weil dieses besser aufgewickelt werden kann. Wenn die Medien in der Vor- oder Zwischenvakuumkammer 2 zugeführt werden, müssen die spannungsführenden Teile nicht elektrisch isoliert sein. Damit aber keine Kurzschlüsse zwischen den Kabeln und der geerdeten Kammerwand auftreten, muss die Kammerwand mit einer Über- oder Durchschlagssicherung, d. h. einer Isolierung versehen sein.

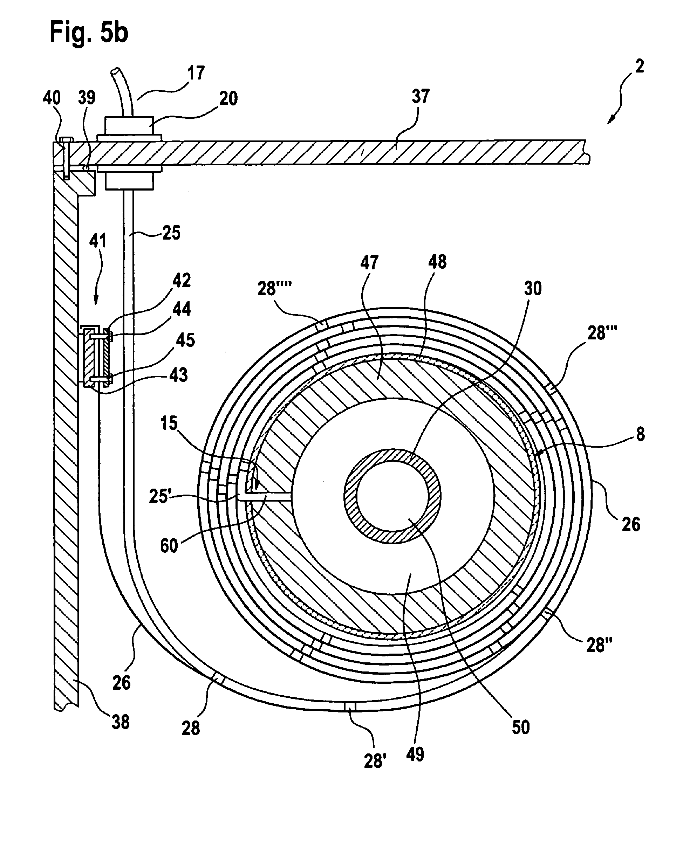

Fig. 5b zeigt einen Schnitt entlang C-C durch einen Ausschnitt der in Fig. 1 dargestellten Vorvakuumkammer 2 mit der Achse 8 und dem daran angeschlossenen Leitungselement 25 für die Kühlmittelversorgung. Das Kühlmittel gelangt von außen über das Leitungselement 17 und den Anschluss 20 in das in der Vorvakuumkammer 2 angeordnete Leitungselement 25. Bei den Leitungselementen 25, 17 handelt es sich um Schläuche, die vorzugsweise aus einem gummielastischen Material bestehen.

Der Schlauch 25 ist zumindest teilweise auf der Bandfeder 26 angeordnet und wird dort mittels der Elemente 28, 28', 28", 28'", 28"" gehalten. Die Bandfeder 26 ist mit dem an ihr befestigten Schlauch 25 um die Achse 8 gewickelt.

Das Ende 25' des Schlauchs 25 ist über eine Klemm- oder Steckvorrichtung 15 mit dem äußeren Ring 47 der Achse 8 verbunden. Dabei kann es sich auch um eine Kombination aus Klemm- und Steckvorrichtung handeln.

Das Kühlmittel gelangt vom Schlauch 25 über eine Öffnung 60 in den Bereich 49. Bei diesem Bereich 49 handelt es sich somit um das Zuflusssystem, über welches das Kühlmittel, beispielsweise Wasser, in die Rohrkathode 3 gelangen kann. Bei dem Bereich 50 handelt es sich um das Abflusssystem, über welches das Kühlmittel wieder aus der Rohrkathode 3 abgeführt wird. Es ist jedoch auch möglich, das Kühlmittel über den Bereich 50 in die Rohrkathode 3 zu führen. In dem Fall wird das Kühlmittel über den Bereich 49 aus der Rohrkathode 3 abgeführt und über den Schlauch 25 wieder aus der Vorvakuumkammer 2 geführt. Dies kann beispielsweise über ein Pumpsystem geschehen, welches das Kühlmittel im Vorlauf unter Druck zuführt.

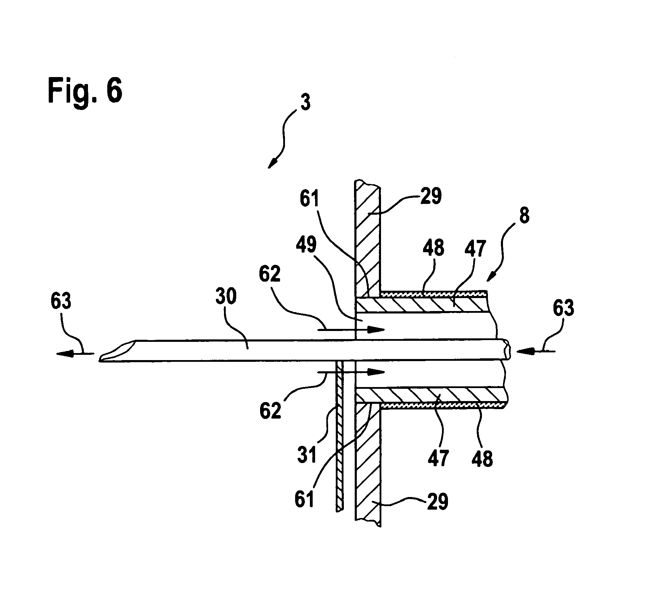

In Fig. 6 ist ein vergrößerter Ausschnitt der in Fig. 3 gezeigten Rohrkathode 3 mit der Achse 8 dargestellt. Die Achse 8 stellt ein Rohrsystem dar mit dem äußeren Ring 47, der das darin angeordnete innere Rohr 30 umgibt. Der äußere Ring 47 kann von einer Isolierschicht 48 umgeben sein.

Die Isolierschicht 48 verläuft nur bis zum Targetträgerrohr 29 der Rohrkathode 3 hin. Dadurch kommt es an der Stelle 61 zum Kontakt des stromführenden inneren Rings 47 mit dem Targetträgerrohr 29 der Rohrkathode 3, wobei das Targetträgerrohr 29 ebenfalls aus einem stromleitenden Material besteht. Damit wird die Rohrkathode 3 direkt mit Strom gespeist.

Wie zu erkennen, wird das Kühlmittel durch das Rohr 30 in die Rohrkathode 3 transportiert, was durch den Pfeil 63 angedeutet ist. Das Kühlwasser fließt im Vorlauf durch das Rohr 30 bis an das jenseitige Ende der Kathode im Innern des Targetrohrs, wo es in das Targetrohr austritt und innerhalb des Targets zurückfließt.

Über den Bereich 49 der Achse 8 kann das Kühlmittel das Innere der Rohrkathode wieder verlassen, was durch die Pfeile 62 angedeutet ist. Das das Innere der Rohrkathode verlassende Kühlmittel wird dann über einen an der Achse 8 angebrachten Schlauch, zum Beispiel den Schlauch 25 abgeführt, wie in Fig. 5b gezeigt.

Wird hingegen das Kühlmittel über den Schlauch 25 in die Achse 8 zugeführt, so gelangt das Kühlmittel über den Bereich 49 in das Innere der Rohrkathode 3 und verlässt die Rohrkathode 3 über das Rohr 30. Dieses Rohr 30 weist somit im Innern der Rohrkathode 3 Öffnungen auf, über die das Kühlmittel die Rohrkathode 3 wieder verlassen kann.

Fig. 7 zeigt einen Ausschnitt einer Bandfeder 51 mit vier darauf angeordneten Leitungselementen 52 bis 55. Bei diesen Leitungselementen 52 bis 55 kann es sich um Kabel oder Schläuche handeln, die aus einem im Wesentlichen flexiblen Material bestehen. Die Leitungselemente 52 bis 55 sind im Wesentlichen parallel zueinander angeordnet und werden mittels Elementen 56, 57 gehalten. Dabei sind die Leitungselemente 52 bis 55 durch die auf der Bandfeder 51 angeordneten U-förmigen Elemente 56, 57 umschlossen. Durch das Festziehen von Verbindungselementen 58, 59, zum Beispiel von Schrauben, ist ein Verrutschen der Leitungselemente 52 bis 55 nicht mehr möglich.

Bei dem Ausführungsbeispiel gemäß den Figuren 1 bis 6 befindet sich der drehbare Aufnehmer 47 außerhalb der Vakuumkammer 1. Er kann sich jedoch auch im Prozessvakuum befinden. Hierbei müssen die spannungsführenden Teile elektrisch isoliert sein, weil sonst parasitäre Plasmen entstehen können und elektrische Überschläge das Sputterplasma negativ beeinflussen.

Der Aufnehmer 47 kann auch in einem zusätzlichen Vorvakuum vorgesehen sein. In diesem Fall braucht man keine Rücksicht darauf zu nehmen, ob Kunststoffe ausgasen und damit den Beschichtungsprozess beeinflussen. Spannungsführende Teile müssen nicht unbedingt isoliert sein. Dafür ist aber eine elektrische Isolation auf der Kammerwand im Bereich der Anschlüsse 20 bis 22 nötig. Weiterhin kann der Aufnehmer auch in Atmosphäre vorgesehen werden. Eine Drehdurchführung für den Drehantrieb ist ohnehin nötig. Es entfallen jedoch Schleifkontakte und drehbare Wasseranschlüsse. Auf die Vakuumtauglichkeit der verwendeten Materialien braucht nicht geachtet zu werden. Aus Sicherheitsgründen müssen jedoch alle spannungsführenden Teile isoliert sein.

## Patentansprüche

1. Zerstäubungsvorrichtung, mit
1.1 einer Vakuumkammer (1),
1.2 einer Rohrkathode (3) in der Vakuumkammer (1),
**gekennzeichnet durch**
1.3 eine mit der Rohrkathode (3) verbundenen, derehbaren Aufnehmer (47), auf dessen Außenseite flexible Leitungselemente (23 - 25, 52 - 55) auf- und abrollbar sind,
1.4 Verbindungselemente (46), mit denen die flexiblen Leitungselemente (23 - 25, 52 - 55) mit dem drehbaren Aufnehmer (47) verbindbar sind.

2. Zerstäubungsvorrichtung nach Anspruch 1, **dadurch gekennzeichnet, dass** die Verbindungselemente (46) eine Klemm- und/oder Steckverbindung sind.

3. Zerstäubungsvorrichtung nach Anspruch 1, **dadurch gekennzeichnet, dass** der drehbare Aufnehmer (47) außerhalb der Vakuumkammer (1) angeordnet ist.

4. Zerstäubungsvorrichtung nach Anspruch 1, **dadurch gekennzeichnet, dass** der drehbare Aufnehmer (47) in der Vakuumkammer (1) angeordnet ist.

5. Zerstäubungsvorrichtung nach Anspruch 1, **dadurch gekennzeichnet, dass** der drehbare Aufnehmer (47) in einer Vorvakuumkammer (2) angeordnet ist.

6. Zerstäubungsvorrichtung nach Anspruch 1, **dadurch gekennzeichnet, dass** der drehbare Aufnehmer (47) rohrförmig ausgebildet ist und ein koaxiales Innenrohr (30) aufweist.

7. Zerstäubungsvorrichtung nach Anspruch 1, **dadurch gekennzeichnet, dass** die flexiblen Leitungselemente (23 - 25, 52 - 55) Stromleitungen sind.

8. Zerstäubungsvorrichtung nach Anspruch 1, **dadurch gekennzeichnet, dass** die flexiblen Leitungselemente Kühlungsschläuche (23 - 25, 52 - 55) sind.

9. Zerstäubungsvorrichtung nach Anspruch 1, **dadurch gekennzeichnet, dass** die flexiblen Leitungselemente (23 - 25, 52 - 55) zumindest teilweise auf einer Bandfeder (26, 51) angeordnet sind.

10. Zerstäubungsvorrichtung nach Anspruch 9, **dadurch gekennzeichnet, dass** die Leitungselemente (23 - 25, 52 - 55) über Verbindungselemente (28; 28'; 28"; 56, 59; 57, 58) mit der Bandfeder (26, 51) fest verbunden sind.

11. Zerstäubungsvorrichtung nach Anspruch 9, **dadurch gekennzeichnet, dass** die Bandfeder (26, 51) aus einem im Wesentlichen flexiblen Material besteht.

12. Zerstäubungsvorrichtung nach Anspruch 9, **dadurch gekennzeichnet, dass** die Bandfeder (26, 51) als Leiter elektrischer Energie vorgesehen ist.

13. Zerstäubungsvorrichtung nach Anspruch 1 oder Anspruch 7, **dadurch gekennzeichnet, dass** die Leitungselemente (23 - 25, 52 - 55) Energieleitungen sind.

14. Zerstäubungsvorrichtung nach Anspruch 1 oder Anspruch 7, **dadurch gekennzeichnet, dass** die Leitungselemente (23 - 25, 52 - 55) Signalleitungen sind.

15. Zerstäubungsvorrichtung nach Anspruch 9, **dadurch gekennzeichnet, dass** die Bandfeder (26, 51) an einer Befestigungsvorrichtung (41) angeordnet ist.

16. Zerstäubungsvorrichtung nach Anspruch 1, **dadurch gekennzeichnet, dass** die Leitungselemente (23 - 25, 52 - 55) mit einer Achse (8) über Verbindungselemente (46) verbunden sind.

17. Zerstäubungsvorrichtung nach Anspruch 15 und Anspruch 16, **dadurch gekennzeichnet, dass** die Länge der Leitungselemente (23 - 25, 52- 55) mindestens der Länge entspricht, die nötig ist, um mit den Verbindungselementen (46) verbunden zu werden, zuzüglich einer Länge, die erforderlich ist, um die Bandfeder (26, 51) mit den an ihr angebrachten Leitungselementen (23 - 25, 52 - 55) einmal um die Achse (8) zu wickeln.

18. Verfahren zum Beschichten von Substraten mit einer Vorrichtung nach Anspruch 1, **gekennzeichnet durch** folgende Schritte:
a) die Rohrkathode (3) wird um einen ersten Winkel von ±150° bis 270° um ihre Längsachse (A-A) in eine erste Richtung gedreht;
b) die Rohrkathode (3) wird um einen zweiten Winkel um ihre Längsachse (A-A) in eine zweite Richtung, die zur ersten Richtung entgegengesetzt ist, bewegt, wobei der zweite Winkel um einen definierten Betrag größer oder kleiner ist als der erste Winkel;
c) die Schritte a) und b) werden so oft wiederholt, bis sich die Rohrkathode (3) mindestens um ±360° um ihre Längsachse (A-A) bewegt hat.

19. Verfahren nach Anspruch 18, **dadurch gekennzeichnet, dass** nachdem sich die Rohrkathode (3) um mindestens ±360° um ihre Längsachse (A-A) bewegt hat, das Verfahren wiederholt wird, wobei die Drehbewegungen nun in die jeweils entgegengesetzten Richtungen erfolgen.

20. Verfahren nach Anspruch 18, **dadurch gekennzeichnet, dass** der Winkel in Schritt b) um etwa 10° größer oder kleiner ist als im Schritt a).

21. Verfahren nach den Ansprüchen 18 bis 20, **dadurch gekennzeichnet, dass** ein drehbarer Aufnehmer (47) vorgesehen ist, der die Drehbewegungen der Rohrkathode (3) mitmacht.

22. Verfahren nach Anspruch 21, **dadurch gekennzeichnet, dass** eine Bandfeder (26, 51) mit daran angeordneten Leitungselementen (23 - 25, 52 - 55) bei der Drehbewegung des Aufnehmers (47) auf diesen gewickelt oder von diesem abgewickelt wird.

## Claims

1. Sputter apparatus with
1.1 a vacuum chamber (1),
1.2 a pipe cathode (3) in the vacuum chamber (1),
**characterized by**
1.3 a rotatable receptor (47) connected with the pipe cathode (3), onto whose outside flexible conducting line elements (23 - 25, 52 - 55) can be wound and from which they can be wound out,
1.4 connecting elements (46), with which the flexible line elements (23 - 25, 52 - 55) are connectable with the rotatable receptor (47).

2. Sputter apparatus as claimed in claim 1, **characterized in that** the connecting elements (46) are a clamp and/or plug connection.

3. Sputter apparatus as claimed in claim 1, **characterized in that** the rotatable receptor (47) is disposed outside of the vacuum chamber (1).

4. Sputter apparatus as claimed in claim 1, **characterized in that** the rotatable receptor (47) is disposed in the vacuum chamber (1).

5. Sputter apparatus as claimed in claim 1, **characterized in that** the rotatable receptor (47) is disposed in a fore-vacuum chamber (2).

6. Sputter apparatus as claimed in claim 1, **characterized in that** the rotatable receptor (47) is formed tubularly and has a coaxial internal tube (30).

7. Sputter apparatus as claimed in claim 1, **characterized in that** the flexible line elements (23 - 25, 52 - 55) are power lines.

8. Sputter apparatus as claimed in claim 1, **characterized in that** the flexible line elements are cooling hoses (23 - 25, 52 - 55).

9. Sputter apparatus as claimed in claim 1, **characterized in that** the flexible line elements (23 - 25, 52 - 55) are at least partially disposed on a spiral flat spring (26, 51).

10. Sputter apparatus as claimed in claim 9, **characterized in that** the line elements (23 - 25, 52 - 55) are fixedly connected with the spiral flat spring (26, 51) via connecting elements (28; 28'; 28"; 56, 59; 57, 58).

11. Sputter apparatus as claimed in claim 9, **characterized in that** the spiral flat spring (26, 51) is comprised of a substantially flexible material.

12. Sputter apparatus as claimed in claim 9, **characterized in that** the spiral flat spring (26, 51) is provided as conductor of electric energy.

13. Sputter apparatus as claimed in claim 1 or claim 7, **characterized in that** the line elements (23 - 25, 52 - 55) are energy lines.

14. Sputter apparatus as claimed in claim 1 or claim 7, **characterized in that** the line elements (23 - 25, 52 - 55) are signal lines.

15. Sputter apparatus as claimed in claim 9, **characterized in that** the spiral flat spring (26, 51) is disposed on a fastening device (41).

16. Sputter apparatus as claimed in claim 1, **characterized in that** the line elements (23 - 25, 52 - 55) are connected with an axle (8) via connecting elements (46).

17. Sputter apparatus as claimed in claim 15 and claim 16, **characterized in that** the length of the line elements (23 - 25, 52 - 55) corresponds at least to the length required for the connection with the connecting elements (46), plus the length required to wind the spiral flat spring (26, 51) with the line elements (23 - 25, 52 - 55) disposed on it once about the axle (8).

18. Method for coating substrates by means of an apparatus as claimed in claim 1, **characterized by** the following steps:
a) the pipe cathode (3) is rotated by a first angle of ± 150° to 270° about its longitudinal axis (A-A) in a first direction;
b) the pipe cathode (3) is moved by a second angle about its longitudinal axis (A-A) in a second direction opposite to the first direction, wherein the second angle is greater or smaller by a defined magnitude than the first angle;
c) steps a) and b) are repeated until the pipe cathode (3) has moved at least by ± 360° about its longitudinal axis (A-A).

19. Method as claimed in claim 18, **characterized in that,** after the pipe cathode (3) has moved by at least ± 360° about its longitudinal axis (A-A), the method is repeated wherein the rotational movements now take place in the particular opposite directions.

20. Method as claimed in claim 18, **characterized in that** the angle in step b) is greater or smaller by approximately 10° than in step a).

21. Method as claimed in claims 18 to 20, **characterized in that** a rotatable receptor (47) is provided, which carries out the rotational movements of the pipe cathode (3) jointly with it.

22. Method as claimed in claim 21, **characterized in that** a spiral flat spring (26, 51), with line elements (23 - 25, 52 - 55) disposed thereon during the rotational movement of the receptor (47) is wound onto it or wound from it.

## Revendications

1. Dispositif de pulvérisation, avec
1.1 une chambre à vide (1)
1.2 une cathode tubulaire (3) située dans la chambre à vide (1),
**caractérisé en ce que**
1.3 un récepteur rotatif (47) relié à la cathode tubulaire (3), sur la face extérieure duquel des éléments de conduction souples (23-25, 52-55) peuvent rouler vers le haut et vers le bas,
1.4 des éléments de liaison (46) permettant de relier les éléments de conduction souples (23-25, 52-55) avec le récepteur rotatif (47).

2. Dispositif pulvérisation selon la revendication 1, **caractérisé en ce que** les éléments de liaison (46) sont constitués d'un assemblage par serrage et/ou par emboîtement.

3. Dispositif de pulvérisation selon la revendication 1, **caractérisé en ce que** le récepteur rotatif (47) est installé à l'extérieur de la chambre à vide (1).

4. Dispositif de pulvérisation selon la revendication 1, **caractérisé en ce que** le récepteur rotatif (47) est installé dans la chambre à vide (1).

5. Dispositif de pulvérisation selon la revendication 1, **caractérisé en ce que** le récepteur rotatif (47) est installé dans une chambre à vide préliminaire (2).

6. Dispositif de pulvérisation selon la revendication 1, **caractérisé en ce que** le récepteur rotatif (47) est conçu en forme de tube et comporte un tube interne coaxial (30).

7. Dispositif de pulvérisation selon la revendication 1, **caractérisé en ce que** les éléments de conduction souples (23-25, 52-55) sont des lignes électriques.

8. Dispositif de pulvérisation selon la revendication 1, **caractérisé en ce que** les éléments de conduction souples (23-25, 52-55) sont des tubes de refroidissement.

9. Dispositif de pulvérisation selon la revendication 1, **caractérisé en ce que** les éléments de conduction souples (23-25, 52-55) sont au moins partiellement disposés sur un ressort de feuillard plat (26, 51).

10. Dispositif de pulvérisation selon la revendication 9, **caractérisé en ce que** les éléments de conduction souples (23-25, 52-55) sont reliés fixement au ressort en feuillard plat (26, 51) par le biais d'éléments de liaison (28, 28', 28" ; 56, 59 ; 57, 58).

11. Dispositif de pulvérisation selon la revendication 9, **caractérisé en ce que** le ressort en feuillard plat (26, 51) est constitué d'un matériau essentiellement souple.

12. Dispositif de pulvérisation selon la revendication 9, **caractérisé en ce que** le ressort de feuillard plat (26, 51) est prévu pour la conduction d'énergie électrique.

13. Dispositif de pulvérisation selon la revendication 1 ou 7, **caractérisé en ce que** les éléments de conduction (23-25, 52-55) sont des conduites d'énergie.

14. Dispositif de pulvérisation selon la revendication 1 ou 7, **caractérisé en ce que** les éléments de conduction (23-25, 52-55) sont des conduites de signaux.

15. Dispositif de pulvérisation selon la revendication 9, **caractérisé en ce que** le ressort de feuillard plat (26, 51) est disposé sur un système de fixation (41).

16. Dispositif de pulvérisation selon la revendication 1, **caractérisé en ce que** les éléments de conduction (23-25, 52-55) sont reliés à un axe (8) par le biais des éléments de liaison (46).

17. Dispositif selon la revendication 15 et la revendication 16, **caractérisé en ce que** la longueur des éléments de conduction (23-25, 52-55) correspond au moins à la longueur nécessaire pour une liaison avec les éléments de liaison (46), plus une longueur nécessaire pour enrouler le ressort de feuillard plat (26, 51), avec les éléments de conduction (23-25, 52-55) fixés dessus, au moins une fois autour de l'axe (8).

18. Procédé pour le revêtement de substrats, avec un dispositif selon la revendication 1, **caractérisé par** les étapes suivantes :
a) la cathode tubulaire (3) est tournée d'un premier angle compris entre ± 150° et ± 270° autour de son axe longitudinal (A-A), dans une première direction ;
b) la cathode tubulaire (3) est déplacée d'un deuxième angle autour de son axe longitudinal (A-A), dans une deuxième direction opposée à la première direction, le deuxième angle étant supérieur ou inférieur au premier angle, d'un montant défini ;
c) les étapes a) et b) sont répétés autant de fois que nécessaire, jusqu'à ce que la cathode tubulaire (3) se soit déplacée d'au moins ± 360° autour de son axe longitudinal (A-A).

19. Procédé selon la revendication 18, **caractérisé en ce qu'**une fois que la cathode tubulaire (3) s'est déplacée d'au moins ± 360° autour de son axe longitudinal (A-A), le procédé est répété, les mouvements de rotation étant à présent effectués dans les sens respectivement opposés.

20. Procédé selon la revendication 18, **caractérisé en ce que** l'angle de l'étape b) est inférieur ou supérieur d'environ 10° par rapport à celui de l'étape a).

21. Procédé selon les revendications 18 à 20, **caractérisé en ce qu'**il est prévu un récepteur rotatif (47) qui accompagne les mouvements de rotation de la cathode tubulaire (3).

22. Procédé selon la revendication 21, **caractérisé en ce qu'**un ressort de feuillard plat (26, 51), avec des éléments de conduction (23-25, 52-55) montés dessus, est enroulé sur ceux-ci ou bien déroulé sur ceux-ci, lors du mouvement de rotation du récepteur (47).
